Europäisches Patentamt

European Patent Office

Office européen des brevets

(19)

(11) EP 0 594 670 B1

(12) **EUROPÄISCHE PATENTSCHRIFT**

(45) Veröffentlichungstag und Bekanntmachung des Hinweises auf die Patenterteilung:
08.10.1997 Patentblatt 1997/41

(21) Anmeldenummer: 92914310.5

(22) Anmeldetag: 06.07.1992

(51) Int Cl.⁶: **H03K 3/03**

(86) Internationale Anmeldenummer:
PCT/EP92/01519

(87) Internationale Veröffentlichungsnummer:
WO 93/02504 (04.02.1993 Gazette 1993/04)

(54) **VORRICHTUNG ZUR ERZEUGUNG VON SCHWINGUNGEN UND DEREN ANWENDUNG**

DEVICE FOR GENERATING OSCILLATIONS AND USE THEREOF

GENERATEUR D'OSCILLATIONS ET SON UTILISATION

(84) Benannte Vertragsstaaten:
DE ES FR GB IT NL

(30) Priorität: 15.07.1991 DE 4123388

(43) Veröffentlichungstag der Anmeldung:
04.05.1994 Patentblatt 1994/18

(73) Patentinhaber: DEUTSCHE THOMSON-BRANDT GMBH
78048 Villingen-Schwenningen (DE)

(72) Erfinder: Rothermel, Albrecht
78048 Villingen-Schwenningen (DE)

(56) Entgegenhaltungen:
EP-A- 0 395 118            US-A- 4 023 110
US-A- 4 517 532

• IBM TECHNICAL DISCLOSURE BULLETIN Bd. 15, Nr. 10, März 1973, New York, US, SS 3108-3109; T.L. JEREMIAH: 'Delay Line Oscillator'
• IBM TECHNICAL DISCLOSURE BULLETIN Bd. 32, Nr. 2, Juli 1989, New York, US, SS 473-474; Phase-Locked Loop with programmable Phase Offset'
• PATENT ABSTRACTS OF JAPAN vol. 14, no. 151 (E-906) 22. März 1990 & JP-A-20 10 922

**Beschreibung**

Die vorliegende Erfindung betrifft eine Vorrichtung zur Erzeugung von Schwingungen nach dem Oberbegriff des Anspruchs 1 und eine bevorzugte Verwendung der erfindungsgemäßen Vorrichtung gemäß dem Oberbegriff des ersten Verwendungsanspruchs.

Vorrichtungen zur Erzeugung von Schwingungen, auch Oszillatoren genannt, geben bekannterweise periodische Schwingungen ab, die einen sinusförmigen, rechteckförmigen, oder sonstigen periodischen Verlauf aufweisen.

Diese Ausgangssignale werden bestimmt durch ihre Amplitude und durch ihre Frequenz f, deren Kehrwert die Periodendauer T, auch Schwingungsdauer genannt, bestimmt. Zur Erzeugung von Rechteck-Ausgangssignalen sind digitale Schaltstufen besonders geeignet.

Eine bekannte Ausführungsform eines Oszillators mit digitalen Elementen stellt der sogenannte Ringoszillator dar, der beispielsweise bekannt ist aus dem Buch "Introduction to VLSI-systems", C. Mead, L. Conway, Addison-Wesley Publishing Company, 1980.

Ein Ringoszillator ist derart aufgebaut, daß eine ungerade Anzahl von Invertern in einer Kette hintereinander in Reihe geschaltet ist, wobei der Ausgang des letzten Inverters mit dem Eingang des ersten Inverters verbunden ist.

Jeder dieser Inverter bewirkt eine Verzögerungszeit und die Schwingungsdauer T des Ausgangssignales wird bestimmt durch die Anzahl der Inverter und der jeweiligen Verzögerungszeit. Die Schwingungsdauer T selber beträgt das zweifach der Gesamtverzögerungszeit.

In IBM Technical Disclosure Bulletin, Nr.10, 10.März 1973, Seiten 3108 - 3109 wird ein Ringoszillator beschrieben, der eine Kette von Verzögerungselementen aufweist und ein periodisches Rechtecksignal abgibt. Der Ringoszillator enthält eine logische Stufe, der ein erstes Signal, das abgeleitet ist vom Ausgangssignal des letzten Verzögerungselements und ein zweites Signal, das abgeleitet ist von einem innerhalb der Verzögerungskette angeordneten Verzögerungselementes, zugeführt werden und die ein Eingangssignal an den Eingang des ersten Verzögerungselements abgibt. Die Periodendauer des Oszillatorsignals entspricht dabei der Gesamtverzögerungszeit der verwendeten Verzögerungselemente. Es sind hier aber noch zusätzliche Mittel notwendig, um die Periodendauer des Oszillatorsignals zu vervielfachen.

Für verschiedene Anwendungen, jedoch insbesondere in denjenigen Fällen, in denen das Ausgangssignal eines Oszillators mittels einer phasengesteuerten (PLL) Schaltung überwacht werden soll, ist es vorteilhaft, wenn die Schwingungsdauer T im wesentlichen der Gesamtverzögerungszeit der verwendeten Inverter-Kette entspricht.

Es ist Aufgabe der vorliegenden Erfindung eine Vorrichtung zur Erzeugung von Schwingungen vorzustellen, die eine Kette von Verzögerungselementen aufweist und die es ermöglicht, periodische Schwingungen mit einer Schwingungsdauer T zu erzeugen, die im wesentlichen der Gesamtverzögerungszeit dieser Kette entspricht und die es mit einfachen Mitteln gestattet die Periodendauer des Oszillatorsignals zu vervielfachen..

Diese Aufgabe wird bei einer gattungsgemäßen Vorrichtung durch die Merkmale des Anspruchs 1 gelöst.

Als geeignete Verzögerungselemente können beispielsweise Inverter oder sonstige dem Fachmann bekannte Baugruppen verwendet werden.

Mit dieser Oszillatoranordnung wird der Vorteil erzielt, daß unter Verwendung einfacher Bausteine ein Oszillator verwirklicht wird, der ein periodisches Rechtecksignal liefert, dessen Schwingungsdauer T und/oder Tastverhältnis TV vorgebbar ist.

Sind Umschaltmittel vorgesehen, die die Position der Abgriffe für das erste bzw. das zweite Signal verändern, kann damit auch die Frequenz und/oder das Tastverhältnis des Ausgangssignales auch noch nach Inbetriebnahme des Oszillators variiert werden.

Mittels einer Sollwertstufe, die beispielsweise als Eingabevorrichtung, als Speicher, oder dergleichen ausgebildet sein kann, und einer Soll-Ist-Vergleichsstufe, die die genannten Umschaltmittel ansteuert, können in weitem Rahmen Ausgangssignale vorgegeben und eingestellt werden.

Bei einer weiteren Weiterbildung sind die Verzögerungselemente dergestalt, daß die Einzel-Verzögerungszeiten von zumindest einzelnen von ihnen veränderbar sind. Durch eine entsprechende Ansteuerung können die Periodendauer und/oder das Tastverhältnis fein abgestuft eingestellt werden.

Eine bevorzugte Verwendung der erfindungsgemäßen Vorrichtung zur Erzeugung von Schwingungen (Oszillator) besteht darin, daß sie als Teil eines Phasendetektors benutzt wird.

Schwingt der Oszillator mit einer Oszillator-Schwingung mit vorgegebenem Frequenzwert, so sind an den Ausgängen der einzelnen Verzögerungselemnte periodische Ausgangssignale abgreifbar, die zueinander phasenverschoben sind.

Diese phasenverschobenen Ausgangssignale werden einer Vergleichsstufe zugeführt, der weiterhin ein zu analysierndes Testsignal zugeführt wird. Die Vergleichsstufe erkennt, wann das Testsignal einen vorgegebenen Wert aufweist und welche der digitalen phasenverschobenen Ausgangssignale einen hohen (logisch "1" bzw. "high") und welche einen niedrigen (logisch "0" bzw. "low") Wert aufweisen. Dadurch kann auf die Phasenlage des periodischen Ausgangssignales zu der des Testsignals geschlossen werden.

Eine Verwendung der genannten Art ist insbesondere dann sehr vorteilhaft, wenn die Werte für die Frequenz und/oder das Tastverhältnis des Oszillator-Signals vorgebbar sind.

Das kann erreicht werden, indem Einzelverzögerungszeiten und/oder Positionen von zumindest einzelnen Verzögerungselementen verändert werden.

Eine weitere bevorzugte Verwendung des erfindungsgemäßen Oszillators besteht darin, daß dieser als Teil einer phasengesteuerten (PLL) Schaltung verwendet wird.

Diese vergleicht die Ausgangs-Phase irgendeines der Stufen-Ausgangssignale mit der Soll-Phase eines Sollsignals, und gibt im Falle einer unerwünschten Differenz zwischen diesen beiden Phasen ein Stellsignal ab. Durch dieses können Einzel-verzögerungszeiten und/oder Positionen zumindest einzelner der Verzögerungselemente verändert werden, so daß das genannte Stufen-Ausgangssignal und das Sollsignal in Phase zueinander sind.

Eine derartige Verwendung des erfindungsgemäßen Oszillators kann unter anderem dazu dienen, die Einzelverzögerungszeiten auf vorgegebenen Werten zu halten. Dadurch kann die Phasenverschiebung eines bereits genannten Testsignals sehr genau bestimmt werden.

Weitere Merkmale, Vorteile und Einzelheiten der Erfindung werden in den folgenden Ausführungsbeispielen anhand der Zeichnung erläutert. Dabei zeigen

Fig. 1: ein erstes Ausführungsbeispiel der erfindungsgemäßen Oszillatorvorrichtung,

Fig. 2a, b, c Signalverläufe bei verschiedenen Versionen der Oszillatorvorrichtung gemäß Figur 1,

Fig. 3: ein zweites Ausführungsbeispiel des erfindungsgemäßen Oszillators mit Eingabevorrichtung,

Fig. 4: das Flußdiagramm eines Verfahrens zur Einstellung von Schwingungsdauer und/oder Tastverhältnis TV,

Fig. 5: eine mögliche Realisierung von Verzögerungselementen,

Fig. 6: eine bevorzugte Verwendung der erfindungsgemäßen Oszillatorvorrichtung als Teil eines Phasendetektors;

Fig. 7: Ausgestaltungsbeispiele der logischen Stufe.

Bevor auf die Beschreibung der Ausführungsbeispiele näher eingegangen wird, sei darauf hingewiesen, daß die in den Figuren einzeln dargestellten Blöcke lediglich zum besseren Verständnis der Erfindung dienen. Üblicherweise sind einzelne oder mehrere dieser Blöcke zu Einheiten zusammengefaßt. Diese können in integrierter oder Hybridtechnik oder als programmgesteuerter Mikrorechner bzw. als Teil eines zu seiner Steuerung geeigneten Programmes realisiert sein. Die in den einzelnen Stufen enthaltenen Elemente können jedoch auch getrennt ausgeführt werden.

Im Folgenden werden Mittel und Signalverläufe in den Figuren jeweils mit denselben Referenzzeichen versehen und auf sie wird, wenn sie einmal beschrieben wurden, in der weiteren Beschreibung nur soweit eingegangen, wie es für das Verständnis der vorliegenden Erfindung notwendig ist.

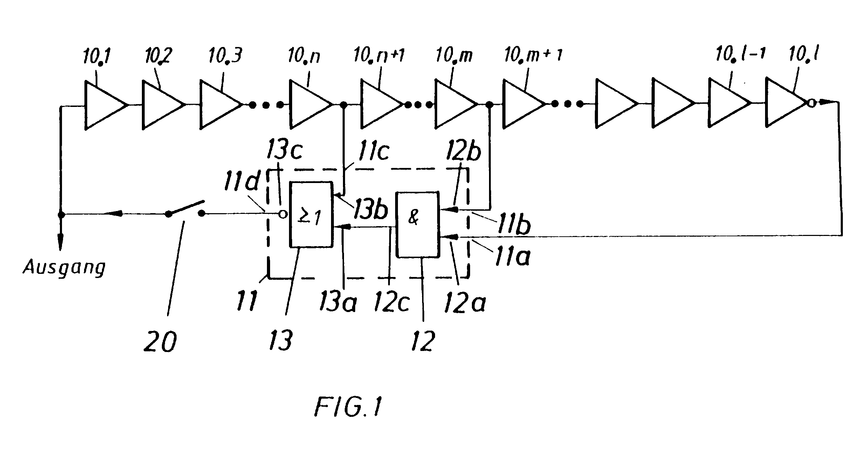

Figur 1 zeigt ein erstes Ausführungsbeispiel der erfindungsgemäßen Oszillatorvorrichtung.

Eine Kette von Verzögerungselementen 10.1, ..., 10.l ist hintereinander in Reihe geschaltet. Eine logische Stufe 11, die in diesem Ausführungsbeispiel ein UND-Gatter 12 und ein NOR-Gatter 13 aufweist, ist mit ihrem ersten Eingang 11a, der mit dem ersten Eingang 12a des UND-Gatters 12 identisch ist, an den Ausgang des letzten Verzögerungselementes 10.l, das als Inverter ausgebildet ist, angeschlossen.

Der zweite Eingang 11b der logischen Stufe 11, welcher dem zweiten Eingang 12b des UND-Gatters 12 entspricht, ist verbunden mit dem Ausgang eines Verzögerungselementes 10.m. Dessen Ausgang ist weiterhin mit dem Eingang des Verzögerungselementes 10.m+1 verbunden.

Der Ausgang 12c des UND-Gatters 12 führt zu einem ersten Eingang 13a des NOR-Gatters 13. Dessen zweiter Eingang 13b, der dem dritten Eingang 11c der logischen Stufe 11 entspricht, verbunden ist mit dem Ausgang eines Verzögerungselementes 10.n, der zusätzlich zu dem Eingang des Verzögerungselementes 10.n+1 führt.

Der Ausgang 13c des NOR-Gatters 13, welcher dem Ausgang 11d der logischen Stufe 11 entspricht, führt zu dem ersten Anschluß eines Schalters 20, dessen zweiter Anschluß mit dem Eingang des ersten Verzögerungselementes 10.1 verbunden ist. Hier liegt auch das Ausgangssignal der Oszillatorvorrichtung an.

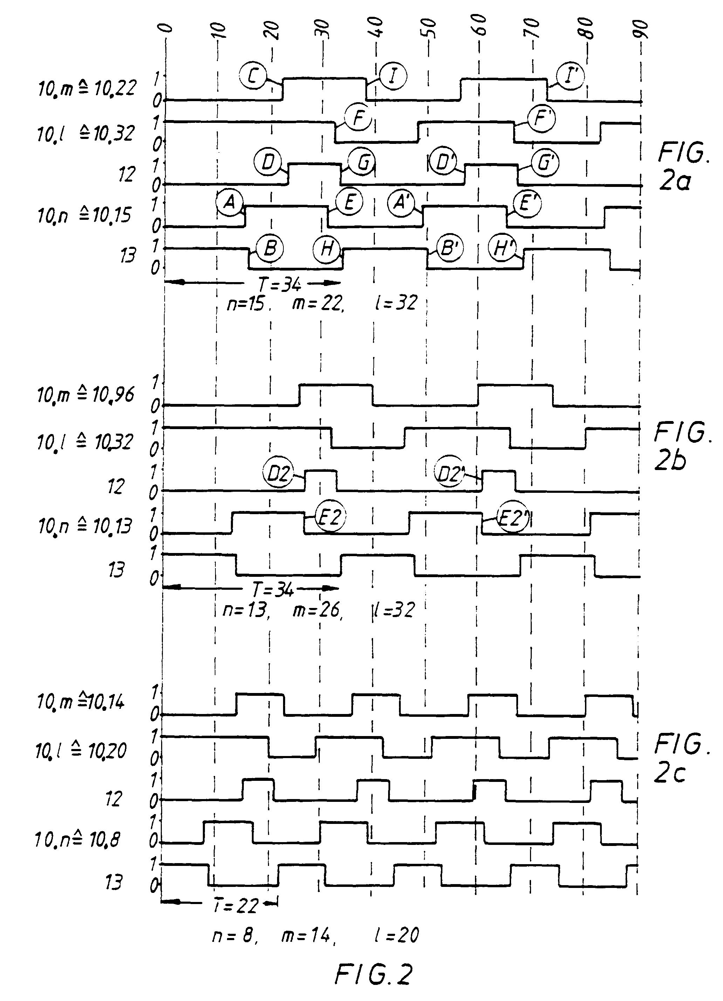

Die Funktion von Versionen des Oszillators gemäß Figur 1 wird nun mit Hilfe der Diagramme der Figur 2, bestehend aus den Figuren 2a, b, c, beschrieben.

Bei einer ersten Version des Ausführungsbeispiels besteht die Kette aus 32 Verzögerungselementen, d.h. l = 32. Damit wird das letzte Verzögerungselement mit 10.32 bezeichnet. Für m wird 22 gesetzt, so daß der Ausgang des 22ten Verzögerungselementes 10.22 zu dem zweiten Eingang 11b der logischen Stufe 11 führt. Weiterhin ist der Ausgang des 15ten (n) Verzögerungselementes 10.15 mit dem dritten Eingang 11c der logischen Stufe 11 verbunden.

Nun wird zunächst davon ausgegangen, daß sämtliche Eingänge der Verzögerungselemente 10.1, ..., 10.32 auf logisch "0" (low) liegen. Damit gibt das 32te Verzögerungselement 10.32, welches als Inverter ausgeführt ist, an seinem Ausgang ein Signal mit logisch "1" (high) ab. Da am zweiten Eingang 12b des UND-Gatters 12 zunächst low anliegt, gibt dieses an seinem Ausgang 12c ein Low-Signal an den ersten Eingang 13a des NOR-Gatters 13 ab. Da ebenfalls am zweiten Eingang 13b des NOR-Gatters 13 ein Low-Signal anliegt, wird am Ausgang 13c des NOR-Gatters 13 ein High-Signal zur Verfügung gestellt.

In Figur 2a sind untereinander die zeitlichen Verläufe der Ausgangssignale der Verzögerungselemente 10.22, 10.32, des Und-Gatters 12, des Verzögerungselementes 10.15, sowie des NOR-Gatters13 dargestellt. Im weiteren wird davon ausgegangen, daß jedes der Verzögerungselemente eine Verzögerungszeit von einer Zeiteinheit habe, wie sie durch die oberste Zeile der Fig. 2a definiert ist.

Auch das UND-Gatter 12 und das NOR-Gatter 13 weisen jeweils eine Verzögerung von einer Zeiteinheit auf.

Zum Zeitpunkt t = 0 wird der Schalter 20 geschlossen, womit an dem Eingang des ersten Verzögerungselementes 10.1 das High-Signal des Ausgangs 13c vom NOR-Gatter 13 angelegt wird. Dadurch wird eine erste Front, d.h. ein übergang von "low" nach "high", verursacht, welche nach insgesamt 15 Zeiteinheiten (t = 15) den Ausgang des Verzögerungselementes 10.15 (10.n) und damit den zweiten Eingang 13b des NOR-Gatters13 erreicht (Flanke A). Das bewirkt, daß zum Zeitpunkt t = 16 am Ausgang 13c des NOR-Gatters 13 ein Low-Signal vorliegt (Flanke B), welches dem Eingang des ersten Verzögerungsgliedes 10.1 zugeführt wird. Dadurch wird eine zweite Front, d.h. ein übergang von "high" nach "low", verursacht, die ab dem Eingang des ersten Verzögerungselementes läuft.

Zum Zeitpunkt t = 22 hat die erste Front den Ausgang des Verzögerungselementes 10.22 erreicht, wodurch ein High-Signal an den zweiten Eingang 12b des UND-Gatters 12 gelegt wird (Flanke C). Das bewirkt zum Zeitpunkt t = 23, da auch an dem ersten Eingang 12a ein High-Signal vorhanden ist, daß am Ausgang 12c des Gatters 12 ein High-Signal anliegt (Flanke D). Dieses liegt gleichzeitig am ersten Eingang 13a des NOR-Gatters 13 an, wodurch jedoch dessen Verhalten nicht beeinflußt wird, da bereits am zweiten Eingang 13b ein High-Signal anliegt.

Zum Zeitpunkt t = 31 hat die zweite Front den Ausgang des Verzögerungselementes 10.15 und damit den zweiten Eingang des NOR-Gatters 13 erreicht (Flanke E). Da jedoch an dessem ersten Eingang noch das High-Ausgangssignal des UND-Gatters 12 anliegt, wird zunächst nichts weiter bewirkt. Zum Zeitpunkt t = 32 erreicht die erste Front den Ausgang des letzten Verzögerungselementes 10.32. Da dieses letzte Verzögerungselement 10.32 als Inverter ausgebildet ist, bewirkt die erste Front, daß ein Umschalten von "high" nach "low" erfolgt (Flanke F). Dieses Low-Signal liegt gleichzeitig am ersten Eingang 12a des UND-Gatters 12 an, wodurch dieses an seinem Ausgang 12c zum Zeitpunkt t = 33 ein Low-Signal zur Verfügung stellt (Flanke G), das gleichzeitig am ersten Eingang 13a des NOR-Gatters 13 anliegt und an dessen Ausgang 13c zum Zeitpunkt t = 34 ein Umschalten von logisch "0" auf logisch "1" bewirkt (Flanke H).

Dieses Ausgangssignal liegt gleichzeitig am Eingang des ersten Verzögerungselementes 10.1 an und bewirkt eine dritte Front, die durch die Kette von Verzögerungselementen 10.1,...,10.32 fortschreitet und analog zu dem bereits Genannten Umschaltungen der entsprechenden Gatter 12 bzw. 13 bewirkt. Dadurch werden Flanken A', B', C', usw. verursacht, die eine analoge Bedeutung zu den bereits beschriebenen Flanken A, B, C, usw. haben.

Damit liegt am Ausgang der Oszillatorvorrichtung ein periodisches Signal an, dessen Verlauf mit dem Ausgangssignal des NOR-Gatters 13 identisch ist und in Figur 2a als unterste Kurve eingezeichnet ist. Man erkennt, daß die Periodendauer T = 34 Zeiteinheiten beträgt. Das entspricht der Gesamtverzögerungszeit der 32 Verzögerungselemente 10.1,...,10.32 sowie zusätzlich der Gatter 12 und 13. Das heißt,

$$T = l + 2.$$

Das Tastverhältnis TV dieses Signales, welches hier definiert ist als die Zeit in der das Signal "high" ist, zu der Zeit in der das Signal "low" ist, beträgt

$$TV = 16 \text{ Zeiteinheiten} : 18 \text{ Zeiteinheiten}.$$

Dieses Tastverhältnis wird bestimmt durch die Position des n-ten Verzögerungselementes 10.n:

$$TV = n + 1 / (l + 1 - n).$$

Der Zähler der rechten Seite dieser Beziehung ergibt sich daraus, daß die erste Front n Zeiteinheiten benötigt, um zum Ausgang des n-ten Verzögerungselementes 10.n zugelangen. Nach einer weiteren Zeiteinheit, also insgesamt nach n+1 Zeiteinheiten, erfolgte das Umschalten am Ausgang 13c des NOR-Gatters 13. Bis dahin ist das Oszillator Ausgangssignal high.

Der Nenner, d.h. die Zeit, in der das Oszillator-Ausgangssignal low ist wird bestimmt durch

$$T - (n + 1) = l + 1 - n.$$

Die Schwingungsdauer T ist direkt abhängig von der Anzahl der Verzögerungselemente, wenn für n und m folgende Bedingungen eingehalten werden:

1.) n muß kleiner oder gleich l/2 sein.
Dann tritt die Flanke E (s. Figur 2a) zeitlich vor der Flanke F auf. Im anderen Fall, d.h. also falls n größer als l/2 ist, tritt die Flanke E zeitlich nach der Flanke F auf und damit wird das Ende der Periode des Ausgangssignals von Gatter 13 nicht durch das Ausgangssignal von Element 10.32 bestimmt, die ein direktes Maß für die Anzahl der Verzögerungselemente darstellt.

2.) m muß kleiner als 2 * n sein.

Falls m größer als 2 * n ist, also wenn in diesem Beispiel m größer als 30 wäre, würde die Flanke C der Kurve 10.m bewirken, daß die Flanke D der Ausgangskurve von Gatter 12 nach der Flanke E der Kurve 10.15 ansteigt, wodurch ein Sprung im Ausgangssignal 13 verursacht würde.

3.) m muß größer oder gleich sein als l - (n + 1).

Andernfalls würde die Flanke I der Kurve 10.m vor der Flanke F der Kurve 10.l abfallen. Damit würde sowohl die Flanke G des Ausgangssignales von Gatter 12 als auch das Ausgangssignal von Gatter 13 nicht direkt von der Größe l, d.h. von der Anzahl der Verzögerungselemente abhängen.

Somit ergibt sich, daß die von den Ausgängen der Verzögerungselemente 10.n, 10.m und 10.l abgegriffenen Signale derart gewählt werden müssen, daß ein erstes Umschalten des Oszillator-Ausgangssignals (Flanke B, B',...) von dem Ausgangssignal des n-ten Verzögerungselementes (Flanke A, A',...) und ein zweites Umschalten des Oszillator-Ausgangssignales (Flanke H, H',...) von dem Umschalten des letzten Verzögerungselementes 10.l (Flanke H, H',...) bewirkt wird. Dabei sind Verzögerungen durch die logische Stufe 11 zu berücksichtigen.

Eine derartige Funktionsweise wird bei diesem Ausführungsbeispiel dadurch realisiert, daß das Ausgangssignal des m-ten Verzögerungselementes 10.m durch die logische Stufe 11 wie angegeben verarbeitet wird. Dabei ist m wie angegeben zu wählen.

Das Vorhandensein des Schalters 20 dient zunächst dazu, die Funktionsweise des Ausführungsbeispiels besser zu beschreiben. Denkbar ist jedoch weiterhin, daß er als Ein/Ausschalter dient.

Falls die logische Stufe eine andere als die genannte Verzögerung bewirkt, so ändern sich entsprechend die Werte für die Schwingungsdauer T und das Tastverhältnis TV.

Signalverläufe für eine weitere Version des ersten Ausführungsbeispiels sind in Figur 2b dargestellt. Dabei wurden folgende Parameter gewählt:

n = 13, m = 26, l = 32.

Die dargestellten Verläufe ergeben sich analog zu denen der Figur 2a, wenn wiederum davon ausgegangen wird, daß zum Zeitpunkt t = 0 der Schalter 20 geschlossen wird und eine erste Front, die einen übergang von low zu high darstellt, von dem ersten Verzögerungselement 10.1 anfängt zu weiteren Verzögerungselementen zu laufen. Zum Zeitpunkt t = 13 erreicht diese erste Front den zweiten Eingang 13b des NOR-Gatters 13, wodurch zum Zeitpunkt t = 14 eine zweite Front am Eingang des ersten Verzögerungselementes verursacht wird, die von high nach low führt. Die weitere Bestimmung der dargestellten Signalverläufe ergibt sich analog wie in der zur Figur 2a gehörenden Beschreibung.

Es sei darauf hingewiesen, daß in dieser Variante ein kritischer Punkt auftritt, da m = 2 * n ist, tritt die Flanke E2 des Ausgangssignals von Verzögerungselement 10.13 sowie die Flanke D2 des Ausgangssignals des Gatters 12 zum selben Zeitpunkt (t=17) auf. In der hier gemachten Darstellung soll das keine Auswirkung auf das Ausgangssignal des Gatters 13 haben, was in der Praxis jedoch nicht gewährleistet ist.

Signalverläufe einer weiteren Version des Ausführungsbeispiels von Figur 1 sind in der Figur 2c dargestellt. Dabei wurden gewählt

n = 8, m = 14, l = 20.

Man erkennt hier deutlich, daß die Periodendauer T den oben genannten Angaben entspricht, nämlich

$$T = l + 2 = 22 \text{ Zeiteinheiten.}$$

Die weiteren Verläufe der Signale können analog zu den bereits genannten hergeleitet werden und es soll an dieser Stelle nicht weiter darauf eingegangen werden.

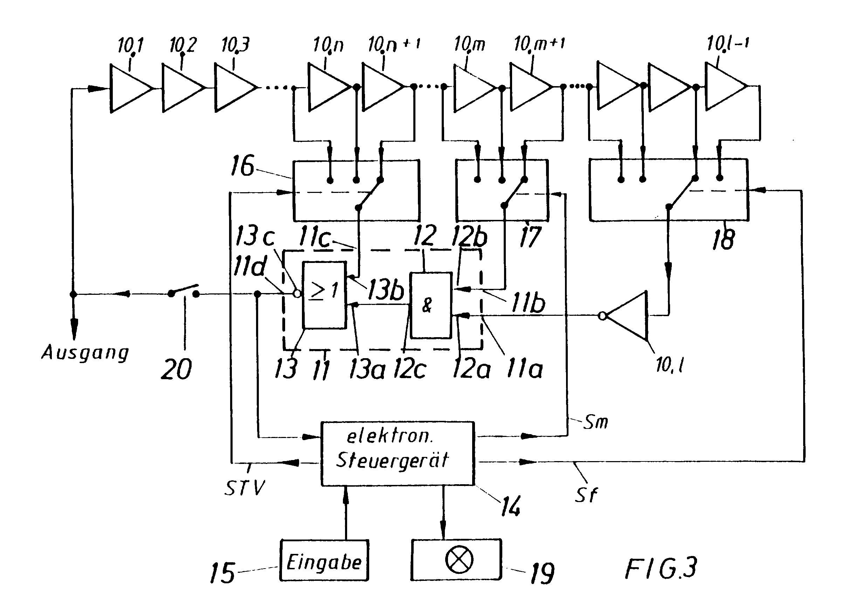

Ein weiteres Ausführungsbeispiel der Erfindung ist in Figur 3 dargestellt. Dort ist neben der Oszillatorvorrichtung, die die Verzögerungselementen 10.1, ..., 10.l-1 sowie das letzte Verzögerungselement 10.l umfaßt, ein elektronisches Steuergerät 14 dargestellt, das Signale von einer Eingabeeinheit 15 erhält. Über diese können Sollwerte für die Frequenz fsoll, entsprechend dem Kehrwert der Schwingungsdauer, sowie das Tastverhältnis TVsoll eingegeben werden.

Ein weiterer Eingang des Steuergerätes 14 ist mit dem Ausgang 11d der logischen Stufe 11 verbunden. Das elektronische Steuergerät 14 gibt ein Signal STV an den Steuereingang eines Tastverhältnis-Umschalters 16 ab, an dessen Schalteingängen die Ausgänge der Verzögerungselemente 10n+1, 10.n, ... angeschlossen sind. Der Schaltausgang des Tastverhältnis-Umschalters 16 ist mit dem dritten Eingang 11c der logischen Stufe 11 verbunden.

Das elektronische Steuergerät 14 gibt weiterhin ein Steuersignal Sm an den Steuereingang eines zweiten Umschalters 17 ab, an dessen Umschalteingängen die Ausgänge der Verzögerungselemente 10.m+1, 10.m, ... anliegen. Sein Schaltausgang ist mit dem zweiten Eingang 11b der logischen Stufe 11 verbunden.

Das elektronische Steuergerät 14 gibt weiterhin ein Signal Sf an den Steuereingang des Frequenz-Umschalters 18 ab, an dessen Umschalteingängen die Ausgänge der Verzögerungselemente 10.l-1, 10.l-2, ... anliegen.

Das elektronische Steuergerät 14 ist weiterhin mit einer Anzeigevorrichtung 19 verbunden, über die Fehler bei Eingabe der Frequenz fsoll und/oder des Tastverhältnisses TVsoll angezeigt werden können.

Es versteht sich, daß die Anzeigevorrichtung 19 sowohl als einfache Fehler-"Lampe" als auch als Anzeigedisplay ausgebildet sein kann, über das in alphanumerischen Zeichen eine ausführliche Fehlerbeschreibung erfolgen kann.

Ferner können Betriebszustände des Oszillators mittels der Anzeigevorrichtung 19 angezeigt werden.

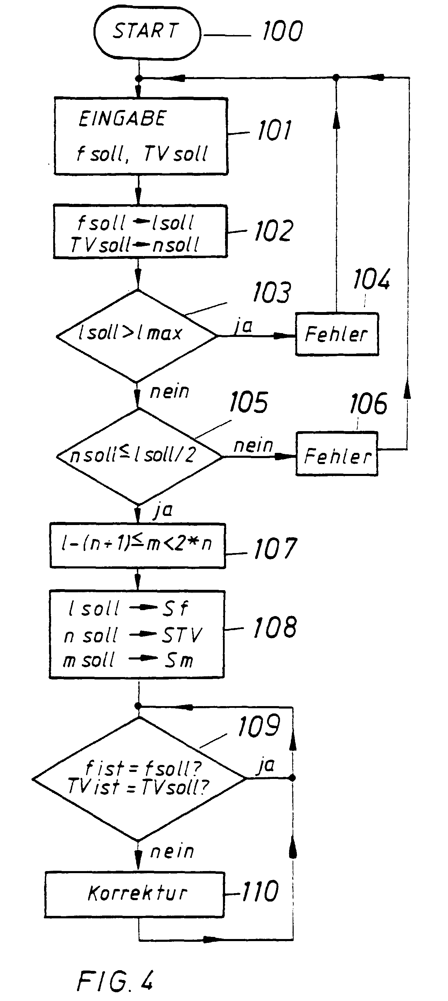

Die Funktion des Ausführungsbeispiels der Figur 3 wird mit Hilfe des Flußdiagramms der Figur 4 erläutert.

Nach dem Start in Schritt 100 erfolgt die Eingabe von Sollwerten für die Frequenz fsoll und für das Tastverhältnis TVsoll über die Eingabeeinheit 15 (Schritt 101). In Schritt 102 wird aus dem Wert fsoll ein Wert Isoll bestimmt, und aus dem Wert TVsoll wird ein Wert msoll ermittelt.

In Schritt 103 wird ermittelt, ob der Wert Isoll größer als ein Maximalwert Imax ist, der der Gesamtanzahl von Verzögerungselementen entspricht eventuell unter Berücksichtigung weiterer Verzögerungen, wie beispielsweise durch die Gatter 12, 13. Falls "ja" führt das erfindungsgemäße Verfahren zu Schritt 104, in dem über die Anzeigeeinheit 19 ein Fehler angezeigt wird. Falls in Schritt 103 festgestellt wird, daß Isoll kleiner oder gleich Imax ist, führt das Verfahren zu Schritt 105 in dem ermittelt wird, ob nsoll kleiner oder gleich ist als Isoll/2. Falls "nein", so führt das wiederum zu einer Fehleranzeige (Schritt 106) und falls das Ergebnis aus Schritt 105 "ja" ist fährt das Verfahren bei Schritt 107 fort. Nach den Schritten 104 und 106 wird erneut zu dem Schritt 101 geführt, in dem eine erneute Eingabe von Frequenz fsoll und Tastverhältnis TVsoll erfolgen kann.

In Schritt 107 wird ein Wert m bestimmt gemäß den oben gemachten Ausführungen. Anschließend folgt ein Schritt 108, in dem

- Isoll einem geeigenten Steuersingal Sf,
- nsoll einem geeigneten Steuersignal STV und
- m einem geeigenten Steuersignal Sm

zugeordnet wird.

Diese Steuersignale werden an die Steuereingänge der entsprechenden Umschalter 16, 17, bzw. 18 weitergeleitet. In Schritt 109 wird das Ausgangssignal, das am Ausgang 13c des NOR-Gatters 13 anliegt, bezüglich seiner Frequenz und seines Tastverhältnisses mit den Sollwerten verglichen und falls eine Korrektur erforderlich ist, wird diese in Schritt 110 durchgeführt. Nach dem Schritt 110 bzw. falls keine Korrektur in Schritt 109 erforderlich ist, erfolgt erneut die Abfrage von Schritt 109.

Der Vergleich des Ausgangssignales mit den vorgegebenen Sollwerten erfolgt mittels dem Fachmann bekannten Maßnahmen.

So ist es beispielsweise denkbar, Istwerte mittels eines Frequenz- und Phasenmeßgerätes zu messen und daraus erhaltene Werte zur Korrektur zu verwenden. Weiterhin ist auch der Eibsatz einer PLL-Schaltung denkbar.

Bei den Ausführungsbeispielen der Figur 3 kann somit die Schwingungsdauer T variiert werden, wenn die Gesamtanzahl I von Verzögerungselementen verändert wird durch Ansteuerung des Frequenz-Umschalters 18.

Das Tastverhältnis TV kann vorgegeben werden durch durch Ansteuerung des Tastverhältnis-Umschalters 16.

Die genannten Ansteuerungen der Umschalter 16, 18 verändern jeweils die Positionen der Verzögerungselemente von denen das erste, das zweite, bzw. das dritte Signal abgegriffen werden.

Denkbar ist jedoch ebenfalls, daß Einzel-Verzögerungszeiten zumindest einzelner Verzögerungselemente verändert werden. Damit können die Schwingungsdauer T und/oder das Tastverhältnis TV fein abgestuft variiert werden.

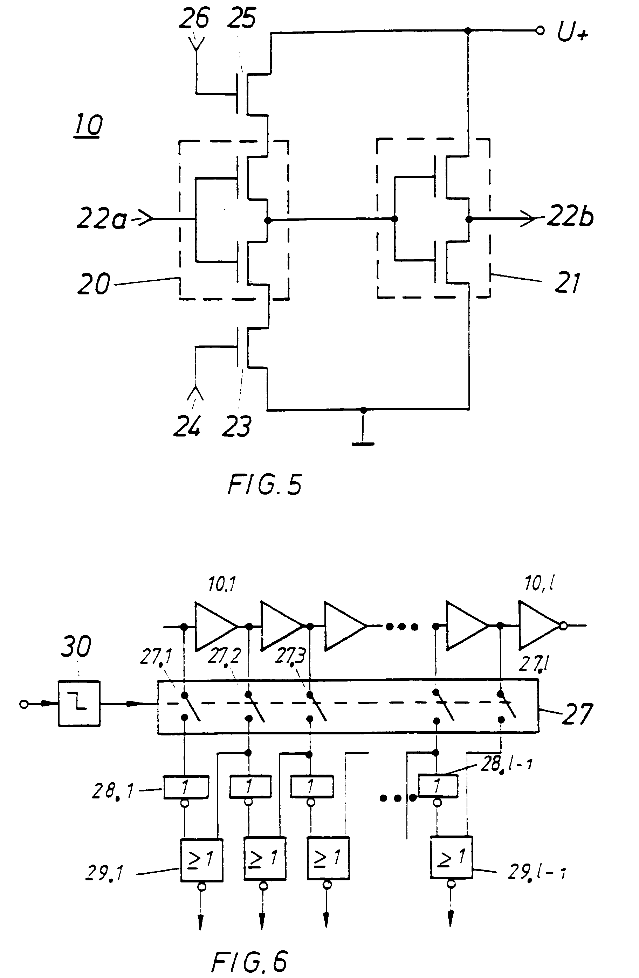

Eine bevorzugte Ausführungsform von einem der verwendeten Verzögerungselemente 10.1...10.I-1 ist in Figur 5 dargestellt.

So kann durch Hintereinanderschalten eines ersten Inverters 20 und eines zweiten Inverters 21 ein am Eingang 22a anliegendes Signal am Ausgang 22b verzögert und nicht-invertiert ausgegeben werden.

Die jeweiligen Verzögerungszeiten der Inverter 20, 21 bestimmen die Einzelverzögerungszeit des in Fig. 5 dargestellten Verzögerungselementes 10.

Zusätzlich sind in Fig. 5 ein erster Verzögerungs-Transistor 23, dessen Gate-Anschluß zu einem ersten Steuer-Eingang 24 führt und ein zweiter Verzögerungs-Transistor 25 vorgesehen, dessen Gate-Anschluß zu einem zweiten Steuer-Eingang 26 führt.

Die Verzögerungs-Transistoren 23, 25 sind mit dem ersten Inverter 20, einem Masseanschluß und einer positiven Versorgungsspannung U+ in Reihe geschaltet.

Durch Ansteuersignale an einem der Steuereingänge 24, 26 wird der Source-Drain-Widerstand des angesteuerten Verzögerungs-Transistors 23 bzw. 25 verändert.

Bei einer Erhöhung dieses Widerstandes für den ersten Verzögerungs-Transistor 23 erhöht sich die Verzögerungszeit des ersten Inverters 20 für am Eingang 22 anliegende Signale mit einer Flanke zu logisch "low".

Bei einer Erhöhung des Widerstandes für den zweiten Verzögerungs-Transistor 25 erhöht sich die Verzögerungszeit des ersten Inverters 20 für am Eingang 22 anliegende Signale mit einer Flanke zu logisch "high".

Damit kann durch Ansteuersignale an den Steuereingängen 24, 26 die Einzelverzögerungszeit des ersten Inverters 20 und damit des gesamten Verzögerungselementes 10 variiert werden.

Eine bevorzugte Anwendung von Oszillatorvorrichtungen mit Verzögerungselementen ist in Fig. 6 dargestellt.

Eine Schaltvorrichtung 27 weist eine Vielzahl von Schaltelementen 27.1,...,27.I auf, welche als Register, Speicher, Halteglieder (latch) oder dergleichen realisiert sein können. Die Eingänge der Verzögerungselemente 10.1,...,10.I sind jeweils mit einem der ersten Schaltanschlüsse der Schaltelemente 27.1,...,27.I verbunden.

Zweite Schaltanschlüsse der Schaltelemente 27.2,...,27.I-1 sind jeweils sowohl mit einem Eingang von Invertierern 28.2,...,28.I-1 als auch mit einem ersten Eingang von NOR-Gattern 29.1,...,29.I-2 verbunden.

Der zweite Schaltanschluß des ersten Schaltelementes 27.1 führt nur zu dem Eingang eines ersten Invertierers 28.1 und der zweite Schaltanschluß eines letzten Schaltelementes 27.l ist nur mit dem ersten Eingang eines NOR-Gatters 29.l-1 verbunden.

Die Ausgänge der Invertierer 28.1,...26.l-1 sind jeweils mit zweiten Eingängen der NOR-Gatter 29.1,..., 29.l-1 verbunden.

Ein Steuereingang der Schaltvorrichtung 27 führt zu dem Ausgang einer Schwellwertstufe 30, der ein zu analysierendes Testsignal an derem Eingang zugeführt wird.

Die Anordnung gemäß Fig. 6 dient dazu, die Phasenlage des Testsignals in Bezug auf diejenige Schwingung festzustellen, mit der die Oszillatorvorrichtung schwingt.

Das Testsignal bewirkt bei Überschreiten bzw. Unterschreiten eines vorgegegeben Schwellwertes, daß die Schwellwertstufe 30 zu dem betreffenden Zeitpunkt an ihrem Ausgang ein Signal mit logisch "high" oder mit "low" abgibt.

Bei einer Flanke nach "high" möge die Schaltvorrichtung 27 derart angesteuert werden, daß alle Schaltelemente 27.1,...,27.l geschlossen werden. In Abhängigkeit davon, bei welchem Eingangssignal der Verzögerungselemente 10.1,...,10.l ein Übergang von "high" auf "low" vorliegt, gibt eines der NOR-Gatter 29 ein "high"-Signal ab.

Dieses kann durch eine nichtdargestellte Auswertestufe festgestellt und daraufhin auf die Phasenlage des Testsignales bezüglich der Oszillator-Schwingung geschlossen werden.

Bevorzugterweise sind die Eingangsstufen der Invertierer 28 derart ausgebildet, daß zuletzt kurzzeitig angelegte Spannungen gespeichert werden, beispielsweise auf den Eingangs(Gate-) Kapazitäten.

Eine entsprechende Speicherung von Ausgangssignalen kann jedoch auch durch die nicht dargestellte Auswertestufe bzw. ihr angeschlossene Speicher erfolgen.

Denkbar ist weiterhin, daß die Schaltvorrichtung 27 als Register, Speicher, Halteglied (latch) oder dergleichen ausgebildet ist und eine Speicherung von Signalen hier erfolgt.

Werden anstelle der NOR-Gatter EXCLUSIV-NOR-Gatter verwendet, treten zusätzlich high-Ausgangssignale auf bei einem Übergang von "Low" nach "high".

Versionen dieses Anwendungsbeispiels können Kombinationen von Merkmalen enthalten, wie sie zuvor anhand der beschriebenen Ausführungsbeispiele genannt wurden.

So ist insbesondere die Einstellung von Werten der Schwingungsdauer T und/oder des Tastverhältnisses TV durch Veränderung von Positionen und/oder Einzel-Verzögerungszeiten von Verzögerungselementen vorteilhaft.

Als Testsignal kann beispielsweise ein Fernseh-Horizontal Synchronisations-Impuls dienen. Dessen Phaselage kann durch den in Fig. 6 dargestellten Phasendetektor bestimmt und durch entsprechende Mittel ausgewertet werden. Dazu ist es vorteilhaft, wenn die Oszillator-Vorrichtung mit genau derselben Frequenz schwingt, wie die Taktfrequenz des Fernsehgerätes.

Das kann sehr gut angenähert werden, wenn die Frequenz der Oszillator-Schwingung durch eine PLL-Schaltung überwacht und durch eine geeignete Ansteuerung der Positionen und/oder Einzelverzögerungszeiten der Taktfrequenz angeglichen wird.

Anstelle der Taktfrequenz können auch andere Soll-Frequenzen der PLL-Stufe zugeführt werden und der Oszillator kann entsprechend abgeglichen werden.

Die logische Stufe 11 kann gebildet werden aus weiteren Kombinationen von Digitalbausteinen, die dem Fachmann bekannt sind.

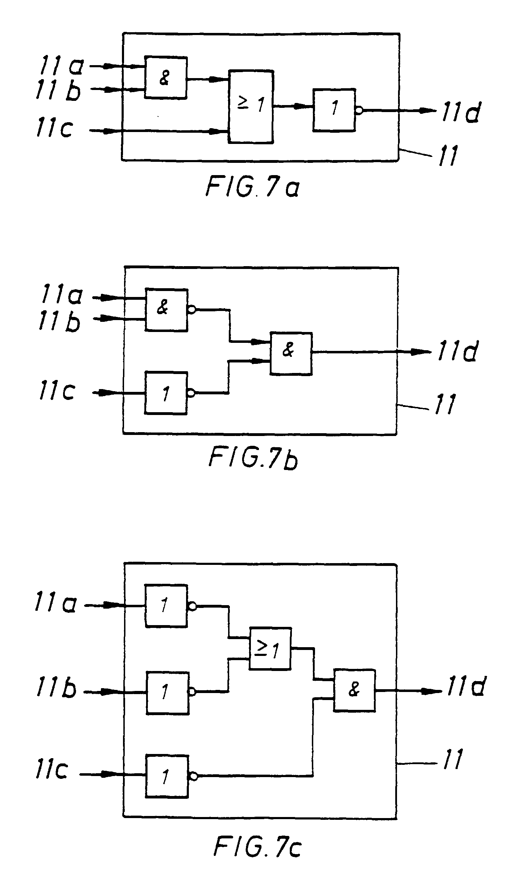

Beispielhafte Ausführungen sind in Fig. 7, bestehend aus den Figuren 7a, b, c angedeutet.

In den bisher dargestellten Ausführungsbeispielen wird von einem letzten Verzögerungselement 10.l mit invertierenden Eigenschaften ausgegangen. Wird stattdessen ein nicht-invertierendes Element verwendet, ist die logische Stufe 11 entsprechend anzupassen.

Versionen der genannten Ausführungsbeispiele können mindestens eine der folgenden Varianten enthalten:

- die Verzögerungselemente 10.1, ..., 10.l-1 können aus jeweils zwei Invertern bestehen, die indentisch sind mit dem l-ten Verzögerungselement 10.l. Damit sind die Verzögerungszeiten nicht für alle Verzögerungselemente gleich, was aufgrund der obigen Ausführungen zu einem entsprechenden Ausgangssignal führt;

- es können Mittel als Teil der logischen Stufe 11 vorgesehen sein, die das erste Umschalten des Ausgangssignales der n-ten Stufe 10.n (Flanke A, A', ...) erkennen und daraufhin ein erstes Umschalten des Oszillator-Ausgangssignals (Flanke B, B', ...) bewirken. Weiterhin wird der entsprechende Zustand des Oszillator-Ausgangssignals beibehalten, bis das erste Umschalten des Ausgangssignals des letzten Verzögerungselementes 10.l erfolgt (Flanke F, F', ...). Dieses wird erkannt und daraufhin das Oszillator-Ausgangssignal umgeschaltet (Flanke H, H', ...). Dadurch kann auf die Zuführung des Ausgangssignals des m-ten Verzögerungselementes 10.m verzichtet werden,;

- werden Stufen-Ausgangssignale Tiefpaßgliedern oder dergleichen zugeführt, so können sinusförmige, dreieckförmige, usw. Ausgangssignale erhalten werden.

Es wird somit ein Oszillator vorgestellt, der eine Kette von Verzögerungselementen enthält und ein Ausgangssignal abgibt, dessen Periodendauer T im wesentlichen der Gesamtverzögerungszeit der Kette entspricht.

Der erfindungsgemäße Oszillator weist eine logische Stufe auf, der Signale, die entlang der Kette abgreifbar sind oder durch zusätzliche Mittel erzeugt werden, zugeführt werden. Die logische Stufe beeinflußt daraufhin das Eingangssignal des ersten in der Kette befindlichen Verzögerungselementes.

Der erfindungsgemäße Oszillator kann als Teil eines Phasendetektors verwendet werden.

**Patentansprüche**

1. Vorrichtung zur Erzeugung von Schwingungen, die eine Kette von 1 Verzögerungselementen (10.1,..., 10.l) aufweist und mindestens ein periodisches Stufen-Ausgangssignal abgibt, das zwischen einem ersten Wert (logisch "1") und einem zweiten Wert (logisch "0") mit einer Periodendauer T geschaltet wird, mit einer logischen Stufe (11), der mindestens

   - ein erstes Signal, das abgeleitet ist von dem Ausgangssignal des letzten Verzögerungselementes (10.l) und
   - ein zweites Signal, das abgeleitet ist von dem Ausgangssignal eines innerhalb der Kette angeordneten Tast-Verzögerungselementes (10.n),

   zugeführt werden und die ein Eingangssignal an den Eingang des ersten Verzögerungselementes (10.1) abgibt, wobei die Periodendauer T einen Wert aufweist, der im wesentlichen der Gesamtverzögerungszeit der verwendeten Verzögerungselemente (10.1,...,10.l) entspricht und das zweite Signal ein Umschalten des Eingangssignales des ersten Verzögerungselementes bewirkt, wodurch das Tastverhältnis (TV) des Stufen-Ausgangssignals entsprechend der Position n des Tast-Verzögerungselementes (10.n) vorgegeben wird und das Stufen-Ausgangssignal abgeleitet wird von Ausgangssignalen mindestens eines der Verzögerungselemente (10.1, ... 10.l) oder der logischen Stufe (11), dadurch gekennzeichnet, daß das Tastverhältnis TV einstellbar und bestimmt ist durch die Beziehung

   $$TV = (n + 1) / (l + 1 - n),$$

   und daß der logischen Stufe (11) ein drittes Signal zugeführt wird, welches einem in der Kette der Verzögerungselemente hinter dem Tast-Verzögerungselement 10.n an der Position m angeordneten Verzögerungselement 10.m entnommen wird, das die logische Stufe (11) derart ansteuert, daß ein Umschalten des Eingangssignals von dessen erstem Wert (logisch "1") auf dessen zweiten Wert (logisch "0") nur durch die steigende Flanke (A) des zweiten Signals und ein Umschalten des Eingangssignals von dessen zweitem Wert (logisch "0") auf dessen ersten Wert (logisch "1") nur durch die fallende Flanke (F) des ersten Signals erfolgt, wobei folgende Bedingungen für n und m einzuhalten sind:

$$n < = l/2$$

$$l - (n + 1) < = m < 2n.$$

2. Verwendung der Vorrichtung zur Erzeugung von Schwingungen nach einem der Ansprüche 1 als Teil eines Phasendetektors, dadurch gekennzeichnet, daß die Vorrichtung zur Erzeugung von Schwingungen phasenverschobene Stufen-Ausgangssignale abgibt, welche gebildet sind von Ausgangssignalen von zumindest einzelnen der in der Kette angeordneten Verzögerungselementen (10.1,...10.l), wobei durch deren Position in der Kette die Phasenverschiebung der Stufen-Ausgangssignale bestimmt wird.

3. Verwendung nach Anspruch 2, dadurch gekennzeichnet, daß die Einzelverzögerungszeiten von zumindest einzelnen in der Kette angeordneten Verzögerungselementen (10.1,...,10.l) vorgebbar sind und daß die Phasenverschiebung der Stufen-Ausgangssignale durch Einstellung von Einzelverzögerungszeiten und/oder durch Verändern der Position von zumindest einzelnen der Verzögerungselemente (10.1,...10.l) vorgebbar ist.

4. Verwendung nach Anspruch 3, dadurch gekennzeichnet, daß die Vorrichtung zur Erzeugung von Schwingungen als Teil einer phasengesteuerten (PLL) Schaltung angeordnet ist, die die Ausgangs-Phase eines Stufen-Ausgangssignals mit der Soll-Phase eines Sollsignals vergleicht und im Falle einer Differenz zwischen diesen beiden Phasen ein Stellsignal abgibt, durch welches Einzelverzögerungszeiten und/oder Positionen zumindest einzelner der Verzögerungselemente (10.1,...10.l) verändert werden.

**Claims**

1. Apparatus for generating oscillations which contains a chain of l delay elements (10.1, ..., 10.l) and emits at least one periodic stage-output signal which is switched between a first value (logical "1") and a second value (logical "0") with a periodic time T, including a logic stage (11) to which there are supplied at least

- a first signal which is derived from the output signal of the last delay element (10.l) and

- a second signal which is derived from the output signal of a key delay element (10.n) arranged within the chain,

and which emits an input signal to the input of the first delay element (10.1), wherein the periodic time T has a value which substantially corresponds to the total delay time of the delay elements (10.1, ..., 10.l) being used and the second signal causes a switch-over of the input signal of the first delay element whereby the duty factor (TV) of the stage-output signal is predetermined in accordance with the position n of the key delay element (10.n) and the stage-output signal is derived from output signals of at least one of the delay elements (10.1, ..., 10.l) or of the logic stage (11),
characterised in that, the duty factor TV is settable and is determined by the relationship

$$TV = (n + 1) / (l + 1 - n),$$

and that there is supplied to the logic stage (11) a third signal which is taken from a delay element (10.m) arranged at a position m beyond the delay element 10.n in the chain of the delay elements, which controls the logic stage (11) in such a way that a switch-over of the input signal from its first value (logical "1") to its second value (logical "0") is only caused by the leading edge (A) of the second signal and a switch-over of the input signal from its second value (logical "0") to its first value (logical "1") is only caused by the first edge (F) of the first signal, wherein the following conditions for n and m must be fulfilled:

$$n <= l/2$$

$$l-(n+1) <= m < 2n.$$

2. Use of the apparatus for generating oscillations in accordance with Claim 1 as part of a phase detector, characterised in that, the apparatus for generating oscillations emits phase displaced stage-output signals which are formed from output signals of at least some of the delay elements (10.1, ..., 10.l) arranged in the chain whereby the phase displacement of the stage-output signals is determined by their position in the chain.

3. Use in accordance with Claim 2, characterised in that, the individual delay times of at least some of the delay elements (10.1, ..., 10.l) arranged in the chain are predeterminable and that the phase displacement of the stage-output signals is predeterminable by setting the individual delay times and/or by altering the position of at least some of the delay elements (10.1, ..., 10.l).

4. Use in accordance with Claim 3, characterised in that the apparatus for generating oscillations is arranged as part of a phase controlled (PLL) circuit which compares the output phase of a stage-output signal with the reference phase of a reference signal and, in the event of a difference between these two phases, emits an adjusting signal by means of which individual delay times and/or positions of at least some of the delay elements (10.1, ..., 10.l) are altered.

## Revendications

1. Un dispositif générateur d'oscillations comportant une chaîne de l éléments de retard (10.1, ..., 10.l) et émettant au moins un signal périodique de sortie d'étage commuté entre une première valeur (logique « 1 ») et une seconde valeur (logique « 0 ») avec une durée de période T et avec un étage logique (11) auquel sont fournis au moins

- un premier signal dérivé du signal de sortie du dernier élément de retard (10.l) et

- un second signal dérivé du signal de sortie d'un élément de retard d'analyse (10.n) situé au sein de la chaîne,

et qui émet un signal d'entrée à l'entrée du premier élément de retard (10.1) et pour lequel la durée de période T présente une valeur sensiblement égale au temps de retard total des éléments de retard utilisés (10.1, ..., 10.l) et le second signal entraîne la commutation du signal d'entrée du premier élément de retard par lequel le taux d'impulsions (TV) du signal de sortie d'étage sera fourni en fonction de la position n de l'élément de retard d'analyse (10.n) et le signal de sortie d'étage sera dérivé des signaux de sortie d'au moins un des éléments de retard (10.1, ..., 10.l) ou de l'étage logique (11), caractérisé en ce que le taux d'impulsions TV est réglable et déterminé par la relation

$$TV = (n + 1)/(l + 1 - n),$$

et que l'étage logique (11) reçoit un troisième signal qui est prélevé sur un élément de retard 10.m à la position m situé dans la chaîne après l'élément de retard d'analyse (10.n) qui commande l'étage logique (11) de telle sorte qu'il se produit une commutation du signal d'entrée de sa première valeur (logique « 1 ») à sa seconde valeur (logique « 0 ») uniquement par le flanc ascendant (A) du second signal et une commutation du signal d'entrée de sa seconde valeur (logique « 0 ») à sa première valeur (logique « 1 ») uniquement par le flanc descendant (F) du premier signal, si les conditions suivantes sont réunies pour n et m :

$$n \leq \frac{1}{2}$$

$$1 - (n + 1) \leq m < 2n.$$

2. Une utilisation du dispositif générateur d'oscillations conforme à la revendication 1 en tant que composant d'un détecteur de phase, caractérisé en ce que le dispositif générateur d'oscillations émet des signaux de sortie d'étage déphasés établis à partir des signaux de sortie d'au moins un des éléments de retard (10.1, ..., 10.l) situés dans la chaîne, pour lesquels il est possible de déterminer le déphasage des signaux de sortie d'étage en fonction de leur position dans la chaîne.

3. Une utilisation selon la revendication 2, caractérisée en ce que les temps de retard d'au moins un des éléments de retard (10.1, ..., 10.l) situés dans la chaîne peuvent être prédéfinis et que le déphasage des signaux de sortie d'étage peut être défini par le réglage des temps de retard et/ou par modification de la position d'au moins un des éléments de retard (10.1, ..., 10.l).

4. Une utilisation selon la revendication 3, caractérisée en ce que le dispositif générateur d'oscillations est utilisé en tant que composant d'un circuit à boucle à verrouillage de phase qui compare la phase de sortie d'un signal de sortie d'étage avec la phase de consigne d'un signal de consigne et en cas de différence entre ces deux phases émet un signal de commande par lequel les temps de retard et/ou la position d'au moins un des éléments de retard (10.1, ..., 10.l) seront modifiés.

*FIG.1*

EP 0 594 670 B1

FIG. 2

FIG.3

START — 100

EINGABE
f soll, TV soll — 101

f soll → l soll
TV soll → n soll — 102

l soll > l max — 103

ja → Fehler — 104

nein

n soll ≤ l soll / 2 — 105

nein → Fehler — 106

ja

$l - (n + 1) \leq m < 2*n$ — 107

l soll → S f
n soll → S TV
m soll → S m — 108

f ist = f soll?
TV ist = TV soll? — 109

ja

nein

Korrektur — 110

FIG. 4

14

FIG. 5

FIG. 6

EP 0 594 670 B1

FIG. 7a

FIG. 7b

FIG. 7c